# EUROPEAN PATENT APPLICATION

(11) **EP 3 336 796 A1**
(43) Date of publication of application: **20.06.2018**
(21) Application number: 15901681.5
(22) Date of filing: 14.08.2015
(51) Int. Cl.: G06Q 50/10, G06Q 50/16

(54) **SIMULATION PROGRAM, SIMULATION METHOD, AND SIMULATION DEVICE**

(71) Applicant: Fujitsu Limited, Kawasaki-shi, Kanagawa 211-8588 (JP)
(72) Inventor: OHORI, Kotaro, Kawasaki-shi Kanagawa 211-8588 (JP); ANAI, Hirokazu, Kawasaki-shi Kanagawa 211-8588 (JP); TAKAHASHI, Shingo, Tokyo 169-8050 (JP); UTSUMI, Shintaro, Tokyo 169-8050 (JP)
(74) Representative: Hoffmann Eitle
(86) International application number: PCT/JP2015/072976
(87) International publication number: WO 2017/029698

(57) **Abstract**

A simulation program (111) according to an embodiment causes a computer (101) to execute a process (S2) of arranging an agent in a virtual space that includes one or a plurality of places where guide information is set, the agent having perception information and behaving according to the perception information in the virtual space. The simulation program further causes the computer to execute a process (S25) of updating the perception information of the agent according to guide information that is provided according to the position of the agent in the virtual space. The simulation program further causes the computer to execute a process (S23) of deteriorating the perception information, degree of the deteriorating being determined on the basis of at least any one of a behavior of the agent and an attribute of the agent.

## Description

### Technical Field

Embodiments of the present invention relate to a simulation program, a simulation method and a simulation apparatus.

### Background Art

Conventionally, in a mall, airport, or the like, people flow simulation is utilized to examine a sign system plan of arrangement of signs representing various guides and guide staffs (collectively referred to as signs below).

In the people flow simulation, signs according to the sign system plan and pedestrian agents imitating pedestrians are arranged in a virtual space corresponding to the mall, airport, or the like. By simulating behaviors of the pedestrian agents based on information that is acquired (perceived) from the signs that are arranged in the virtual space, the flow of pedestrians in the sign system plan is simulated.

### Citation List

### Patent Literature

Patent Literature 1: Japanese Laid-open Patent Publication No. 2000-259603

### Summary of invention

### Technical Problem

There is however a problem of inferior reproducibility of perception information by simulation in that, while behaviors of pedestrian agents are simulated directly according to the information perceived from the signs in the conventional technology, perception information deteriorates with the progress of time and behavior and the degree of deterioration differs also depending on the attribute, such as adult or child, in actual human behaviors.

For example, it is difficult with the conventional technology to reproduce a behavior that is an actual human action, such as "pacing" or "getting lost", losing the connection between a destination and the position of a subject.

According to an aspect, an object is to provide a simulation program, a simulation method and a simulation apparatus to perform people flow simulation enabling reproduction of deterioration of perception information in human behaviors.

### Solution to Problem

A simulation program according to one aspect causes a computer to execute a process of arranging an agent in a virtual space that includes one or a plurality of places where guide information is set, the agent having perception information and behaving according to the perception information in the virtual space. The simulation program further causes the computer to execute a process of updating the perception information of the agent according to guide information that is provided according to the position of the agent in the virtual space. The simulation program further causes the computer to execute a process of deteriorating the perception information, degree of the deteriorating being determined on the basis of at least any one of a behavior of the agent and an attribute of the agent.

### Advantageous Effects of Invention

According to an embodiment of the present invention, it is possible to perform people flow simulation enabling reproduction of deterioration of perception information in human behaviors.

### Brief Description of Drawings

FIG. 1 is a block diagram exemplifying a configuration of a simulation apparatus according to an embodiment.
FIG. 2 is an explanatory diagram to explain spatial information.
FIG. 3 is an explanatory diagram to explain a sign system plan.
FIG. 4 is an explanatory diagram to explain pedestrian information.
FIG. 5 is a flowchart illustrating exemplary operations of the simulation apparatus.
FIG. 6 is an explanatory diagram to explain a virtual space.
FIG. 7 is an explanatory diagram to explain an area that guide information from a sign reaches.
FIG. 8 is an explanatory diagram to explain generation of a pedestrian agent.
FIG. 9 is a flowchart exemplifying a process of updating perception information of the pedestrian agent.
FIG. 10 is an explanatory diagram to explain updating perception information.
FIG. 11 is a flowchart exemplifying a decision-making process on the pedestrian agent.
FIG. 12 is an explanatory diagram to explain drawing a virtual space and pedestrian agents.
FIG. 13 is an explanatory diagram to explain exemplary outputs of simulation results.
FIG. 14 is an explanatory diagram to explain behaviors of a pedestrian agent.
FIG. 15 is an explanatory diagram to explain behaviors of the pedestrian agents.
FIG. 16 is an explanatory diagram to explain behaviors of the pedestrian agents.
FIG. 17 is a block diagram illustrating an exemplary hardware configuration of a simulation apparatus according to the embodiment.

### Description of Embodiments

With reference to the drawings, a simulation program, a simulation method and a simulation apparatus according to an embodiment will be described. Components having the same functions in the embodiment are denoted with the same reference numbers and redundant descriptions will be omitted. The simulation program, the simulation method and the simulation apparatus described in the following embodiment represent an example only and do not limit the embodiments. Each of the following embodiments may be combined as appropriate as long as no inconsistency is caused.

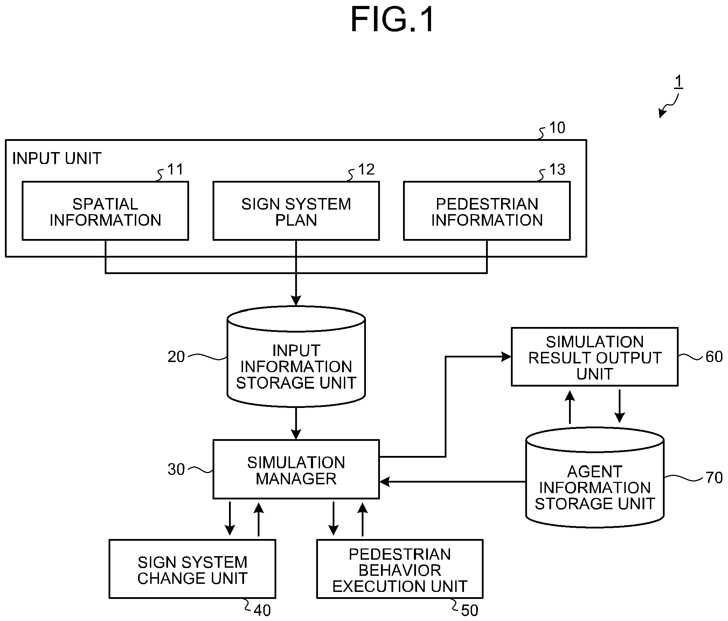

FIG. 1 is a block diagram exemplifying a configuration of a simulation apparatus 1 according to an embodiment. The simulation apparatus 1 illustrated in FIG. 1 is an information processing device, such as a PC (personal computer). The simulation apparatus 1 simulates behaviors of pedestrian agents in a virtual space according to information that is input and performs a people flow simulation imitating a flow of pedestrians. As illustrated in FIG. 1, the simulation apparatus 1 includes an input unit 10, an input information storage unit 20, a simulation manager 30, a sign system change unit 40, a pedestrian behavior execution unit 50, a simulation result output unit 60 and an agent information storage unit 70.

The input unit 10 receives input information about the simulation, including spatial information 11, a sign system plan 12 and pedestrian information 13, from an input device, such as a mouse and a keyboard.

The input information storage unit 20 stores input information that is input from the input unit 10, including the spatial information 11, the sign system plan 12 and the pedestrian information 13, in a storage device, such as a RAM (Random Access Memory) or a HDD (Hard Disk Drive).

The spatial information 11 is information representing a structure of the virtual space of the simulation of a shopping mall, an airport, or the like. Specifically, in the spatial information 11, a cell environment of the virtual space (the area, number of floors, walls, aisles and the position of the facility, etc.,) in which the pedestrian agents in the simulation migrate and a network environment about connection of nodes (aisles and facilities) in the space are written. A user inputs the spatial information 11 about the virtual space of which simulation is to be examined to the simulation apparatus 1.

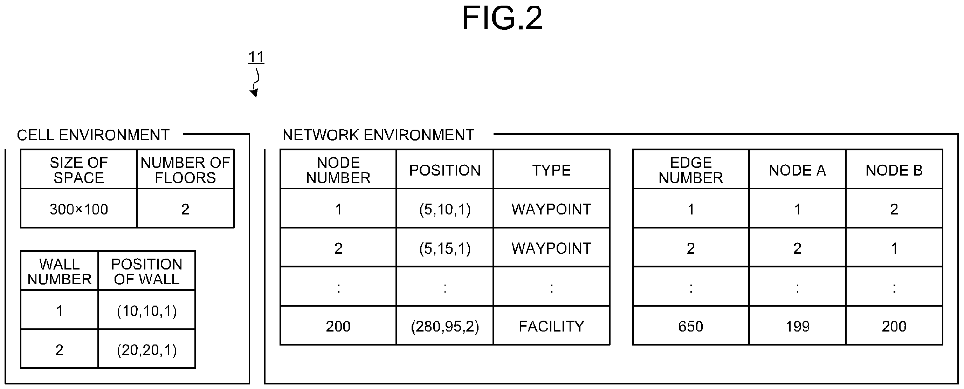

FIG. 2 is an explanatory diagram to explain the spatial information 11. As illustrated in FIG. 2, in the spatial information 11, a cell environment, including the area of the virtual space, the number of floors, wall numbers each representing a cell (wall) that the pedestrian agents are not able to enter and the positions of the walls, is written. In the spatial information 11, a network environment, including a set of coordinates of a node and a type of the node, such as a waypoint or a facility, is written with respect to each node number representing a node. In the network environment, an edge number and node numbers representing nodes connected to each other are written with respect to each edge between nodes between which it is possible to move.

The sign system plan 12 is information representing the arrangement and content of signs representing various guides in the shopping mall, airport, or the like. Specifically, in the sign system plan 12, attributes serving as characteristics of each sign (a position, a degree of conveyance, a distance, an angle and a viewing time) and information (area information, facility information, guide information and storage difficulty) about passing to the pedestrian agent (causing the pedestrian agent to perceive) by each sign are written. The user inputs the sign system plan 12 of which simulation is to be examined to the simulation apparatus 1.

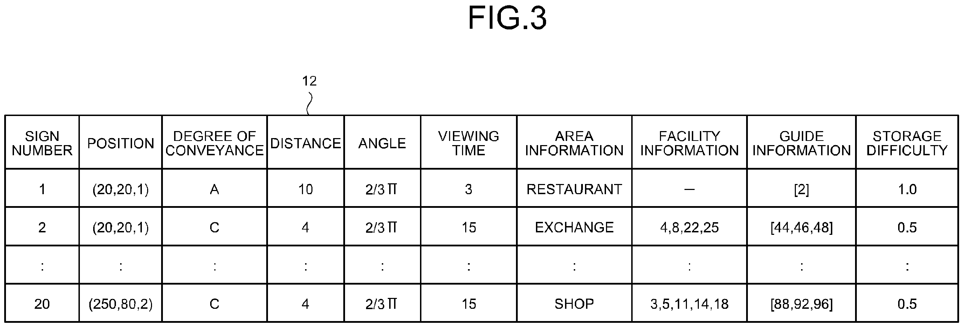

FIG. 3 is an explanatory diagram to explain the sign system plan 12. As illustrated in FIG. 3, in the sign system plan 12, attributes (a position, a degree of conveyance, a distance, an angle and a viewing time) serving as characteristics of each sign are written with respect to each sign number that identifies a sign.

A "position" is a position in which a sign is set in the virtual space. A "degree of conveyance" is a value (for example, an evaluation value from three levels A to C). A "distance" is a value representing a distance in the virtual space enabling the pedestrian agent to perceive the sign. An "angle" is a value representing an angle enabling the pedestrian agent to perceive the sign. A "viewing time" is a value representing a time that the pedestrian agent needs to perceive the content represented by the sign.

With respect to the attributes serving as characteristics of each sign in the sign system plan 12, values that are evaluated on the basis of the size and content of each sign planned to set, etc., are input. For example, for a large sign that conveys less content (for example, implements an area guide without detailed guide of a facility), large values are set for the degree of conveyance and the distance and a small value is set for the viewing time. For a large sign that conveys much content (for example, including detailed guide of the facility), small values are set for the degree of conveyance and the distance and a large value is set for the viewing time.

In the sign system plan 12, information (area information, facility information, guide information and storage difficulty) about perception by the pedestrian agent is written with respect to each sign number that identifies a sign.

"Area information" is information about an area that is passed to the pedestrian agent (that the pedestrian agent is caused to perceive) and is, for example, restaurant, exchange, or shop. "Facility information" is information about a facility that is passed to (that the pedestrian agent is caused to perceive) and is, for example, a number representing the facility. "Guide information" is information that guides the pedestrian agent to the position of the area represented by the area information or of the facility represented by the facility information. For example, "guide information" may be information representing the orientation or route from the position of the sign toward the area or facility with a node number or an edge number in the virtual space. "Storage difficulty" is a value representing the degree of difficulty in forgetting the perceived guide information (hereinafter, also referred to as perception information) of the pedestrian agent who perceives the guide information. For example, a larger value of "storage difficulty" represents that it is difficult for the pedestrian agent to forget the perception information.

For the information about perception of each sign in the sign system plan 12, values obtained through evaluation based on the content of each sign planned to be set are input. For example, for a sign whose sign number is "1" and implementing a guide to an area (omitting a guide to a facility), given values are written for the area information, the guide information and the storage difficulty and NUL data ("-" in the example illustrated in the drawings) is written in the facility information. For a sign whose sign number is "2" and implementing a guide to not only an area but also a facility, given values are written for the area information, the facility information, the guide information and the storage difficult. As described above, the content of the guide of the sign may be categorized into a grade or a class as, for example, a sign implementing a guide to an area or a sign implementing a guide to an area and a facility.

The content of a sign implementing a guide to an area omitting a guide to a facility is more simple than that of a sign implementing a guide to an area and a guide to a facility. The content of such a simple guide is evaluated as being not forgettable to pedestrians. For this reason, a higher value is set for the storage difficulty of a sign with simple guide content. For example, a value set for the storage difficulty of a sign whose sign number is "2" and implementing a guide to not only an area but to a facility is higher than that for the storage difficulty of a sign whose sign number is "1" and implementing a guide to an area.

The pedestrian information 13 is information representing pedestrian agents. Specifically, the pedestrian information 13 is information about an occurrence probability with which a pedestrian agent occurs at an appearance point corresponding to the entrance, or the like, in the virtual space or about a type (attribute) of the pedestrian agent to occur. The types of pedestrian agents are determined by, for example, gender representing male or female and age representing, for example, child (toddler, primary school, junior high-school, or high-school child) or adult (20 to 40, 40 to 60 or over 60). The user inputs the pedestrian information 13 about pedestrians of which simulation is to be examined to the simulation apparatus 1.

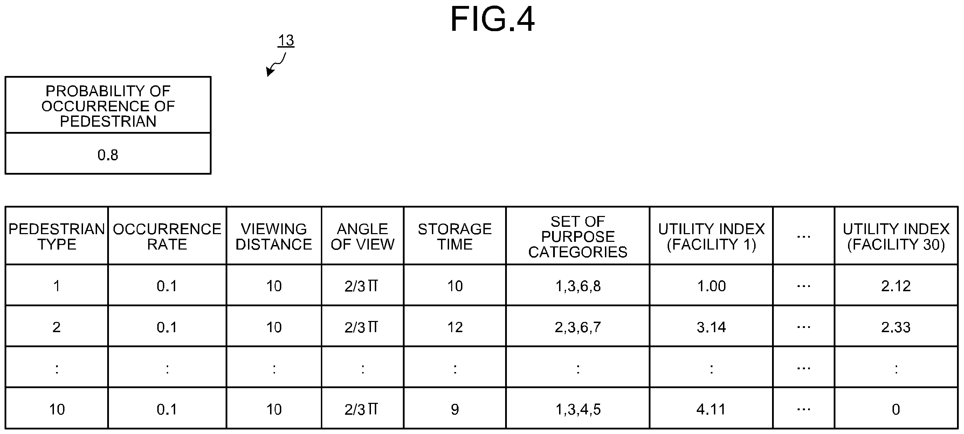

FIG. 4 is an explanatory diagram to explain the pedestrian information 13. As illustrated in FIG. 4, in the pedestrian information 13, a probability of occurrence of a pedestrian agent and characteristics of the pedestrian agent with respect to each number representing a pedestrian type are written. The pedestrian agent characteristics include an "occurrence rate", a "viewing distance", a "viewing angle", a "storage time", a "set of purpose categories" and a "utility index (Facility 1) ... (Facility 30)".

A "occurrence rate" represents a rate at which each pedestrian agent occurs. A "viewing distance" and a "viewing angle" represent a distance and an angle in and at which each pedestrian agent is able to view in the virtual space. A "storage time" represents a time during which each pedestrian agent stores the information that the pedestrian agent perceives. A "set of purpose categories" lists values each representing purposes (for example, meal, shopping, etc.) of behaviors of each pedestrian agent. A "utility index (Facility 1) ... (Facility 30)" represents, in a value, the utility of a facility with respect to each pedestrian agent.

For the content of the pedestrian information 13, values assuming pedestrians visiting the virtual space of the simulation of the mall or airport are input. For example, when there are more use by adults (20 to 40 and 40 to 60) and less use by children (toddler, primary school, junior high-school, and high-school children), the rate of occurrence of a pedestrian of a type corresponding to adult is set larger and the rate of occurrence of a pedestrian of a type corresponding to child is set smaller.

The simulation manager 30 manages a process to simulate behaviors of pedestrian agents in the virtual space, which is a process performed by the pedestrian behavior execution unit 50 on the basis of the input information (the spatial information 11, the sign system plan 12 and the pedestrian information 13) stored in the input information storage unit 20. Specifically, the simulation manager 30 reads the input information stored in the input information storage unit 20 and the results of sequentially simulating behaviors of the pedestrian agents (positional information about the pedestrian agent and the perception information of pedestrian agents) that are stored in the agent information storage unit 70 and outputs the input information and the results to the pedestrian behavior execution unit 50.

The simulation manager 30 deteriorates the perception information of a pedestrian agent on the basis of at least one of the behavior and attribute of the pedestrian agent in the simulation. For example, the simulation manager 30 limits the perception information of the pedestrian agent according to the progress of the simulation by the pedestrian behavior execution unit 50 and outputs the limited perception information to the pedestrian behavior execution unit 50 (details will be described below). Accordingly, the pedestrian behavior execution unit 50 simulates behaviors of the pedestrian agent on the basis of the perception information that is deteriorated by the simulation manager 30.

The simulation manager 30 then outputs, to the simulation result output unit 60, the results of sequential simulations of the behaviors of the pedestrian agent that are performed by the pedestrian behavior execution unit 50 (the positional information about the pedestrian agent and the perception information of the pedestrian agent).

The sign system change unit 40 changes the sign system plan 12 that is stored in the input information storage unit 20 according to an operation instruction that is received from a user on an input device such as, for example, a mouse and a keyboard. Accordingly, the user is able to change the sign system plan 12 properly.

The pedestrian behavior execution unit 50 uses the input information (the spatial information 11, the sign system plan 12 and the pedestrian information 13) as an initial condition and sequentially simulates behaviors of the pedestrian agents. Specifically, the pedestrian behavior execution unit 50 simulates a behavior of a pedestrian agent at the following time on the basis of the result of simulating the behavior of the pedestrian agent until the previous time (the positional information about the pedestrian agent and the perception information of the pedestrian agent). The pedestrian behavior execution unit 50 outputs the results of sequential simulations to the simulation manager 30.

The simulation result output unit 60 stores the results of sequentially simulating behaviors of the pedestrian agent (the positional information about the pedestrian agent and the perception information of the pedestrian agent) in the agent information storage unit 70. The simulation result output unit 60 outputs the simulation results stored in the agent information storage unit 70 by display on the displayed device or printing to a printing device. As for the output of the simulation results, the results of sequential simulations may be output sequentially. The final tally of the simulations over a given time may be output.

The agent information storage unit 70 stores the simulation results, such as information about the pedestrian agent that is the results of the sequential simulations (the positional information and perception information), in a storage device, such as a RAM, HDD, or the like.

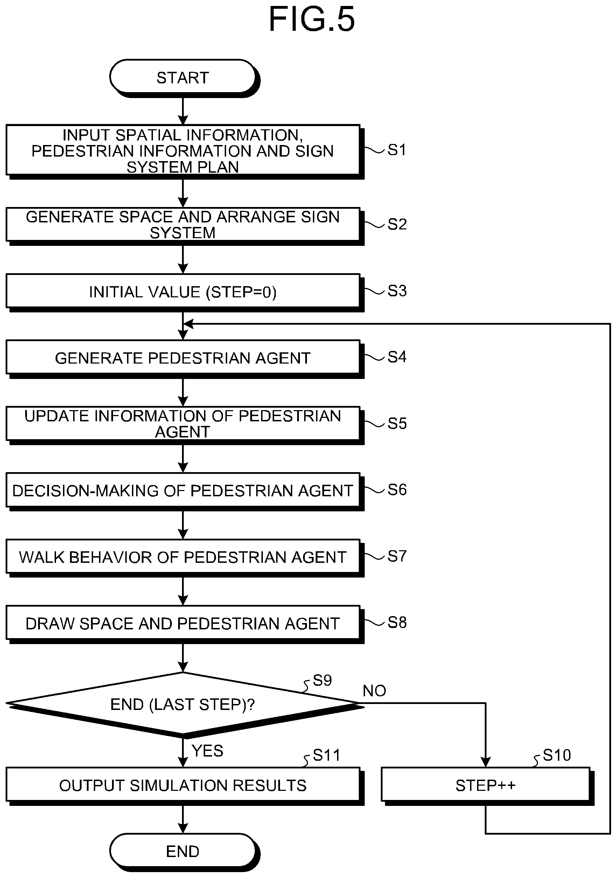

Details of operations of the simulation apparatus 1 will be described. FIG. 5 is a flowchart illustrating exemplary operations of the simulation apparatus 1.

As illustrated in FIG. 5, once the process is started, the input unit 10 receives inputs of the spatial information 11, the pedestrian information 13 and the sign system plan 12 and stores the spatial information 11, the pedestrian information 13 and the sign system plan 12 in the input information storage unit 20 (S1). The simulation manager 30 then generates a virtual space and arranges a sign system in the virtual space on the basis of the spatial information 11 and the sign system plan 12, which are input (S2).

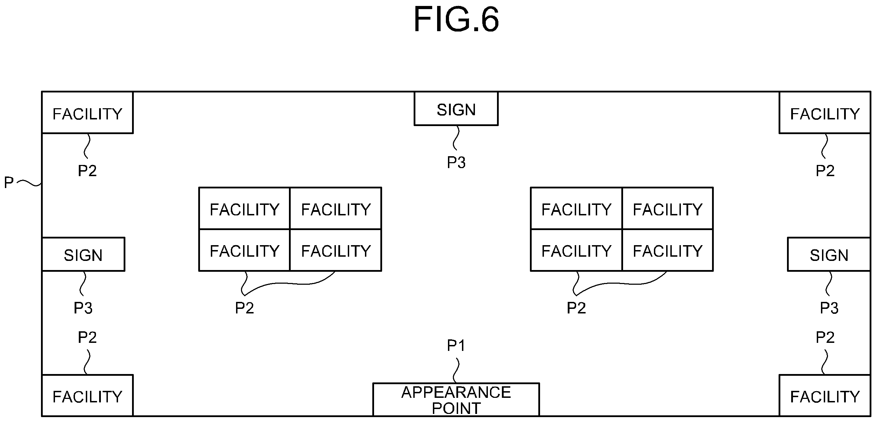

FIG. 6 is an explanatory diagram to explain a virtual space P. As illustrated in FIG. 6, the simulation manager 30 generates the virtual space P based on the cell environment (the area of the space, the number of floors, and the positions of walls) of the spatial information 11. The simulation manager 30 then arranges an appearance point PI, facilities P2, etc., in the virtual space P on the basis of the network environment (the positions and types of nodes and connections of nodes) of the spatial information 11. The simulation manager 30 then arranges signs P3 in the virtual space P on the basis of the positions in the sign system plan 12.

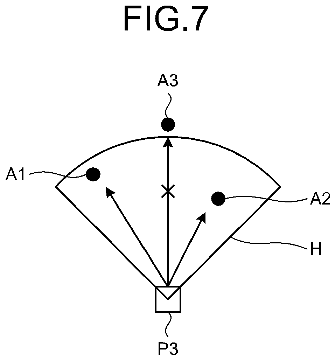

FIG. 7 is an explanatory diagram to explain an area that guide information from the sign P3 reaches. As illustrated in FIG. 7, for the sign P3 arranged in the virtual space P, a reach area H corresponding to the degree of conveyance, the distance and the angle in the sign system plan 12 is set. Accordingly, agents A1 and A2 within the reach area H are able to acquire (perceive) guide information from the sign P3 and the agent A3 outside the reach area H is not able to acquire (perceive) the guide information from the sign P3.

The simulation manager 30 then sets an initial value (Step=0) of the number of steps corresponding to the time at which the simulation starts (S3). Thereafter, when repeating the process from S4 to S10, the simulation manager 30 causes the time of the simulation to progress by incrementing the step that is set. Accordingly, in the process from S4 to S10, the simulation manager 30 causes the pedestrian behavior execution unit 50 to execute a simulation according to the time that progresses according to the steps. Note that any time width of the simulation progressing according to the increment of the step may be set and, for example, the user sets a time width from few seconds to few tens of seconds in advance.

The simulation manager 30 then generates a pedestrian agent at the appearance point P1 on the basis of the occurrence probability and the occurrence rate of each pedestrian type in the pedestrian information 13 (S4). Specifically, on the basis of the generated random number, the simulation manager 30 verifies whether to generate a pedestrian agent according to the occurrence probability and the occurrence rate, which are set. On the basis of the verifying result, the simulation manager 30 generates a pedestrian agent verified as being to occur. The simulation manager 30 allocates identification information, such as an ID (identification data), to each generated pedestrian agent and stores the positon of the pedestrian agent and the perception information of the pedestrian agent in the agent information storage unit 70.

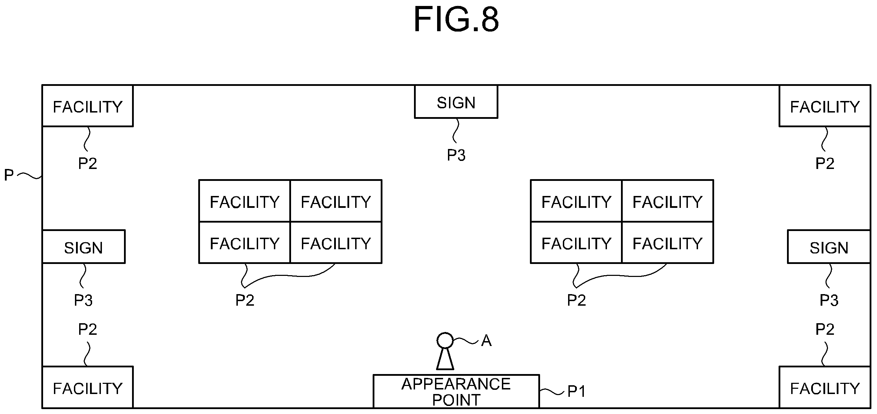

FIG. 8 is an explanatory view to explain generation of the agent A. As illustrated in FIG. 8, on the basis of the occurrence probability and the occurrence rate according to each pedestrian type, an agent A of the type verified as being to occur is generated at the appearance point P1. For example, when the occurrence probability is 0.8, the agent A is generated in the probability of 80% in one step.

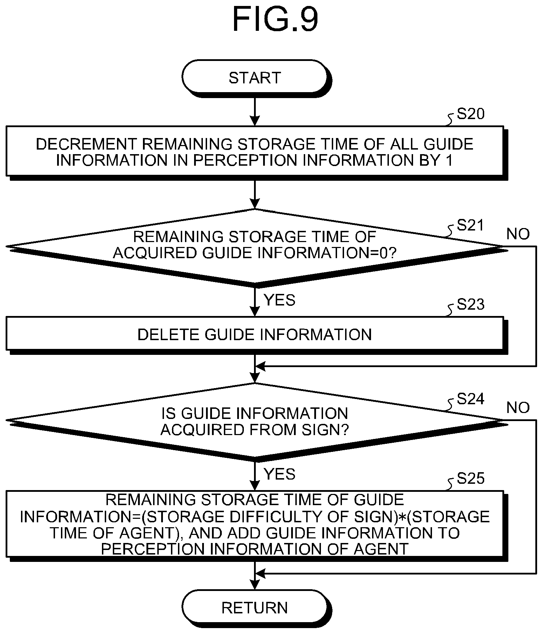

The simulation manager 30 then performs an updating process of reading the perception information of each agent A that is generated in the virtual space P from the agent information storage unit 70 and updating the perception information (S5). FIG. 9 is a flowchart exemplifying the process of updating the perception information of the agent A. Note that FIG. 9 exemplifies an updating process on one agent A; however, the simulation manager 30 performs the updating process in FIG. 9 on all the agents A that are generated in the virtual agents A.

As illustrated in FIG. 9, once the updating process is started, the simulation manager 30 refers to the perception information of the agent A that is stored in the agent information storage unit 70 and decrements the storage time, which is set for all sets of guide information (guide information serving as perception information) in the perception information of the agent A, by one (S20). The process at S20 reduces the remaining storage time, which is set for the guide information, as time of the simulation progresses.

The simulation manager 30 then determines whether the remaining storage time of the acquired guide information is 0 (S21). When the remaining storage time is 0 (YES at S21), the simulation manager 30 deletes the guide information for which the remaining storage time is 0 from the perception information (S23) and proceeds with the process to S24. When the remaining storage time is not 0 (NO at S21), the simulation manager 30 proceeds with the process to S24 without deleting the guide information from the perception information.

Accordingly, during the time when the remaining storage time is not reduced to 0, the perceived guide information is used in the simulation of the agent A. When the remaining storage time is reduced to 0 as the time of the simulation progresses, the perceived guide information is deleted and the use of the perceived guide information to the simulation is limited.

In the embodiment, deleting the perceived guide information (perception information) deteriorates the initial perception information; however, deterioration of the perception information may be realized with a method other than deletion. For example, reading the perception information may be limited to realize deterioration of the perception information. Deleting the perception information may be deleting all the information or deleting part of the information. When part of the information is deleted, the amount of information to be deleted may be increased as the remaining time approaches 0.

At S24, the simulation manager 30 determines whether the agent A acquires (perceives) the guide information from the sign P3 on the basis of the position of the agent A in the virtual space A. Specifically, the simulation manager 30 determines whether the agent A acquires the guide information from the sign P3 according to whether the positon of the agent A is within the reach area H of the sign P3 that is set in the virtual space P.

When the agent A acquires the guide information from the sign P3 (YES at S24), the simulation manager 30 determines that the remaining storage time of the acquired guide information = (the storage difficulty of the sign P3)*(the storage time of the agent A). The simulation manager 30 then adds the remaining time and the guide information to the perception information of the agent A (S25) .

As described above, at S25, when the agent A perceives the guide information, the simulation manager 30 sets the remaining storage time as the initial value of deterioration of the guide information. For example, for the guide information whose storage difficulty set for the sign P3 is high and thus that is forgettable, the value of the remaining storage time set larger. For the agent A whose storage time is long and thus who remembers the perceived guide information for a long time, the value of the remaining storage time is set larger. The remaining storage time may be set on the basis of both or any one of the storage difficulty of the sign P3 and the storage time of the agent A.

The above-described perception information updating process that is in accordance with the progress of the step (the progress of time of the simulation) is exemplified; however, what the process is in accordance with is not limited to the time as long as the process is in accordance with the progress of the simulation. For example, the perception information may be deteriorated on the basis of the progress of the behavior of the agent A, such as the number of steps of the agent A or the number of times the agent A changes the direction. For example, the number of steps of the agent A in accordance with the progress of the simulation and the number of times the direction is changed may be counted as the remaining storage time is counted and, when the counted values are equal to or larger than given thresholds, the perceived guide information may be deleted. As described above, deteriorating the perception information on the basis of not only the progress of time of the simulation but also the progress of the behavior of the agent A enables reproduction of the perception information according to the behavior of the agent A.

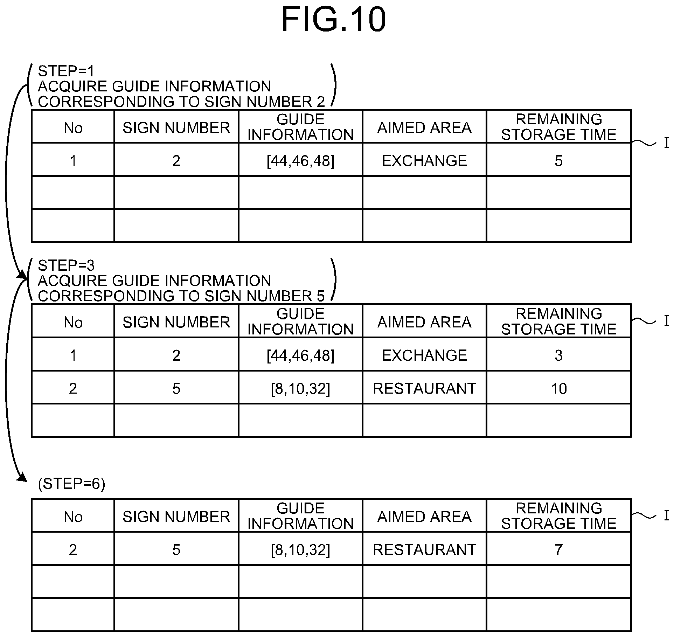

FIG. 10 is an explanatory view to explain updating perception information. Assume that, as illustrated in FIG. 10, the agent A acquires the guide information corresponding to the sign number 2 at the timing at which step=1. In the perception information I of the agent A, the guide information corresponding to the sign number 2 is stored together with the remaining time of 5.

Assume that the agent A acquires guide information corresponding to a sign number 5 at the timing at which step=3. In the perception information I of the agent A, guide information corresponding to the sign number 5 is stored together with the remaining time of 10. As there is a progress by two steps, the remaining storage time is 3 for the guide information corresponding to the sign number 2. As, at the timing at which step=7, the remaining time is 0 for the guide information corresponding to the sign number 2, the guide information is deleted.

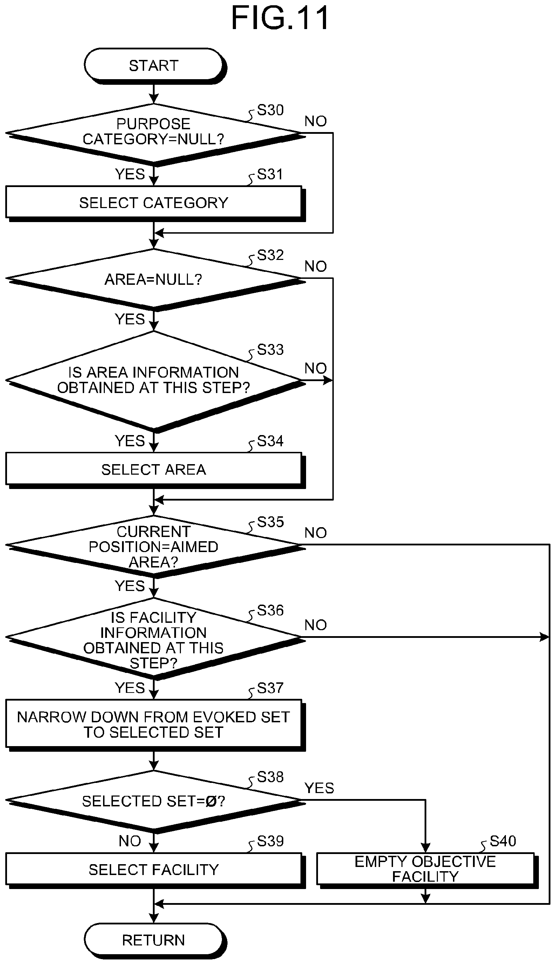

FIG. 5 will be referred back, where, following step S5, the simulation manager 30 implements decision-making of each agent A that is generated in the virtual space P on the basis of the pedestrian information 13 and the perception information I (S6). FIG. 11 is a flowchart exemplifying a decision-making process on the agent A. Note that FIG. 11 exemplifies the decision-making process on one agent A; however, the simulation manager 30 performs the process in FIG. 11 on all agents A that are set in the virtual space P.

As illustrated in FIG. 11, once the process is started, the simulation manager 30 determines whether the purpose category of the agent A is NULL, that is, whether a purpose category is selected (S30). When no purpose category is selected and the purpose category is NULL (YES at S30), the simulation manager 30 selects one category from a set of purpose categories in the pedestrian information 13 (S31).

When a purpose category is already selected and the objective category is not NULL (NO at S30), the simulation manager 30 proceeds with the process to S32 while keeping the objective category selected.

The simulation manager 30 then determines whether the destination area of the agent A is NULL, that is, whether an area corresponding to the selected category among the set of purpose categories is already selected (S32).

When no destination area is selected (YES at S32), the simulation manager 30 determines whether area information about the area corresponding to the category selected from among the set of purpose categories (information about the guide to the area) is obtained (perceived) at this step (S33). Specifically, the simulation manager 30 refers to the perception information I at this step and determines whether the guide information about the aimed area corresponding to the selected category is contained in the perception information I.

When the area information (guide information) about the destination area of the agent A is obtained (perceived) (YES at S33), the simulation manager 30 selects the area whose corresponding area information is obtained (S34). Accordingly, for the agent A, a behavior for the area whose corresponding guide information is perceived is determined. When a destination area is selected (NO at S32) and when the agent A does not perceive the guide information about the destination area of the agent A (NO at S33), the simulation manager 30 skips the process at S34 and proceeds with the process to S35.

The simulation manager 30 determines whether the current position of the agent A is an aimed area that is already selected from among the set of purpose categories (S35). When the current position is the aimed area (YES at S35), the simulation manager 30 determines whether the facility information (information about the guide to the facility) is obtained (perceived) (S36). Specifically, the simulation manager 30 refers to the perception information I at this step and determines whether the guide information about the facility in the aimed area that is the current position is contained in the perception information I.

When the agent A obtains (perceives) the information about the guide to the facility (YES at S36), the simulation manager 30 performs narrowing-down from an evoked set to a selected set (S37). Specifically, the simulation manager 30 narrows down options from the facilities (the evoked set) perceived by the agent A to a selected set according to the purpose of the agent A or the situation. For example, the simulation manager 30 performs the narrowing-down to the selected set by cutting off a facility for which the time to the end of the use of the facility exceeds a given threshold among the evoked set. For example, the simulation manager 30 performs the narrowing down to facilities for which (an estimated time taken to move to the facility) + (wait time) + (use time) < the threshold.

The simulation manager 30 then determines whether the selected set is an empty set (S38) and, when the selected set is not an empty set (NO at S38), the simulation manager 30 selects a facility from among the selected set (S39). Furthermore, when the selected set is an empty set (YES at S38), the simulation manager 30 empties the facility aimed by the agent A (S40).

A known method, such as a discrete choice model, is used to select a facility from among the selected set. For example, the probability that a facility i is selected is calculated by P(i)=expU(i)/∑expU(n) (where n is a facility that is an element of the selected set) and a higher value is selected. Note that U(i)=(the utility index of the facility i) + β1•(the estimated time taken to move to the facility i) + β2•(the wait time at the facility i), where β1 and β2 are weighting values that are set in advance.

FIG. 5 will be referred back. The pedestrian behavior execution unit 50 simulates a walk behavior of each agent A on the basis of the perception information I that is updated at S5 with respect to each agent A and the decision made at S6 (S7). Specifically, the pedestrian behavior execution unit 50 calculates a direction of walk in the step and an amount of the walk in accordance with the perception information I that each agent A perceives and the decision that is made. The result of the simulation at S7 is output to the simulation manager 30 and then is stored in the agent information storage unit 70.

When the perception information I that each agent A perceives is deteriorated or no destination area is determined, a surrounding waypoint is chosen randomly and calculates a walk (a direction and an amount of walk) toward the chosen waypoint is calculated. Accordingly, it is possible to reproduce a behavior that is an actual human action, such as "pacing" or "getting lost", losing the connection between a destination and the position of a subject.

The simulation result output unit 60 draws the virtual space P and each agent A in the virtual space P on the screen of the display device on the basis of the simulation results that are stored in the agent information storage unit 70 (S8).

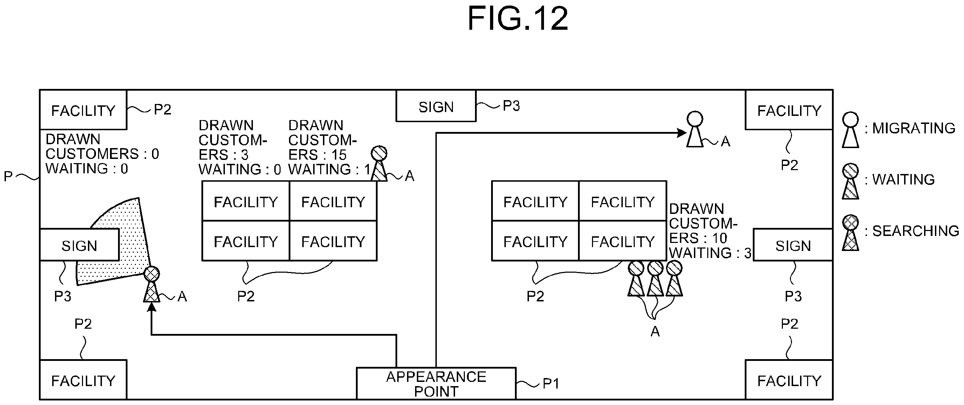

FIG. 12 is an explanatory diagram to explain drawing the virtual space P and the agents A. As illustrated in FIG. 12, on the basis of the simulation result that is calculated at each step, the simulation result output unit 60 draws the current positions of the respective agents A and routes of the move in the virtual space P. The simulation result output unit 60 may change the display mode (for example, color) according to the state of the agent A, for example, migrating, waiting or searching. The simulation result output unit 60 may draw the state of each facility P2 (the number of drawn customers and the number of waiting customers) on the basis of the simulation result that is calculated at each step. Accordingly, the user is able to easily recognize the action of each agent A at each step.

For example, the agent A in the case where perception information I is deteriorated or in the state where no destination area is determined is described as being in migration where the agent A takes an action, such as "pacing" or "getting lost". As for the agent A reaching the aimed facility P2 is described as being waiting. The agent A who perceives the area information (guide information) about the goal area and is moving is drawn as being searching. Accordingly, the user is able to recognize the state of each agent A.

The simulation manager 30 determines whether the process to the last step (the time to end the simulation), which is determined in advance, ends (S9). When the process does not end (NO at S9), the simulation manager 30 increments the number of steps (S10) and returns the process to S4.

When the process ends (YES at S9), the simulation result output unit 60 outputs a final tally obtained by tallying up the simulation results in the agent information storage unit 70 to, for example, the screen of the display device (S11). Accordingly, the user is able to recognize the final tally of the simulations easily.

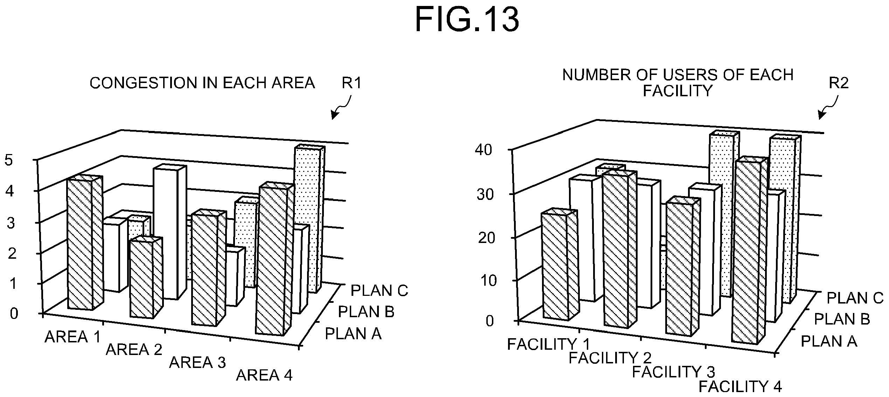

FIG. 13 is an explanatory diagram to explain exemplary outputs of simulation results R1 and R2. As illustrated in FIG. 13, the simulation result output unit 60 tallies simulation results R1 and R2 obtained by simulating each sign system plan (the plans A, B and C) and outputs the simulation results R1 and R2 to the screen of the display device. For example, the simulation result output unit 60 may output the simulation result R1 representing the congestion in each area (the number of users of each facility, the wait time, the time taken to move, and the number of facilities that each agent A uses) in a bar chart. Furthermore, the simulation result output unit 60 may output the simulation result R2 representing the number of users of each facility in a bar chart.

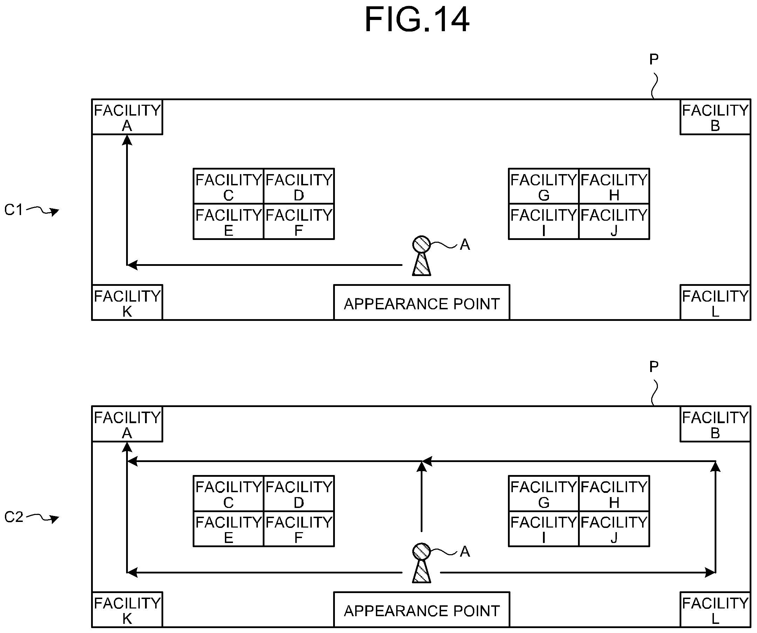

FIGS. 14 to 16 are explanatory diagrams to explain behaviors of pedestrian agents. A case C1 according to FIG. 14 represents the case where, for the agent A who perceives the facility A, deterioration of the perception information according to the progress of the simulation is not performed. A case C2 represents the case where, for the agent A who perceives the facility A, deterioration of the perception information according to the progress of the simulation is performed.

As illustrated in FIG. 14, in the case C1, as deterioration of the perception information is not performed according to the progress of the simulation, the result representing that the agent A moves in the shortest route is obtained. On the other hand, in the case C2, as deterioration of the perception information is performed according to the progress of the simulation, an action of the agent A, such as "pacing" or "getting lost", may be obtained as a simulation result. In this case, during migration, such as "pacing" or "getting lost", the guide of the sign P3 may change the facility to be perceived, which makes it possible to realize people flow simulation according to actual people motions.

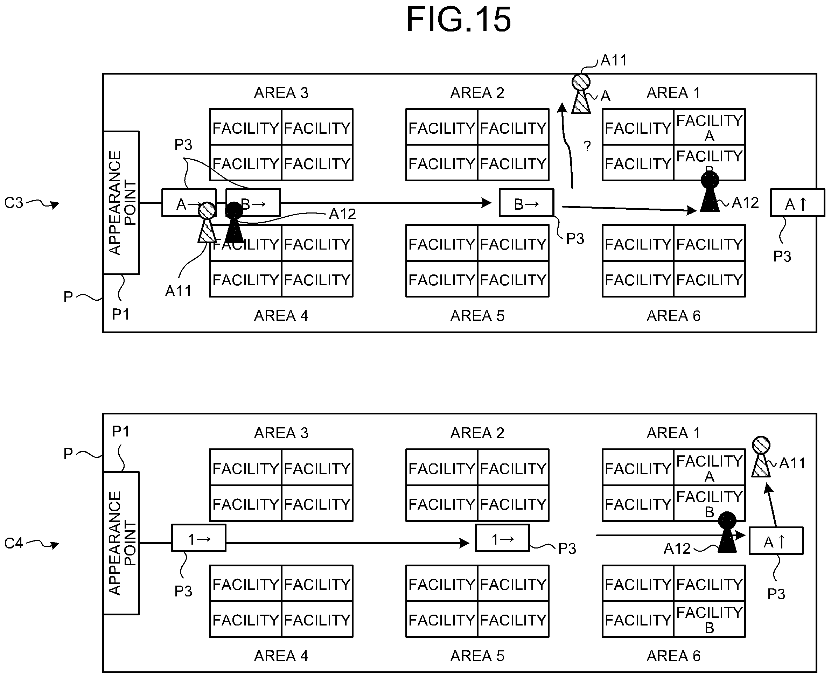

A case C3 in FIG. 15 represents a simulation result of a sign system plan to implement a direct guide to the "facility A" and the "facility B". A case C4 represents a simulation result of a layered sign system plan where a guide to the "area 1" and a guide to the "facility A" are separated. Note that the "facility A" in the "area 1" is a destination of an agent A11, and the "facility B" in the "area 1" is a destination of an agent A12.

As illustrated in FIG. 15, in the case C3, setting a large number of signs P3 results in examination of an unrealistic sign system plan to guide the agents A11 and A12. For example, when the sign P3 serving as a guide to the "facility A" is not set mistakenly, the agent A11 forgetting the guide halfway gets lost halfway. On the other hand, in the case C4, the layered sign system plan enables examination of the plan in consideration of the storage times of the agents A11 and A12.

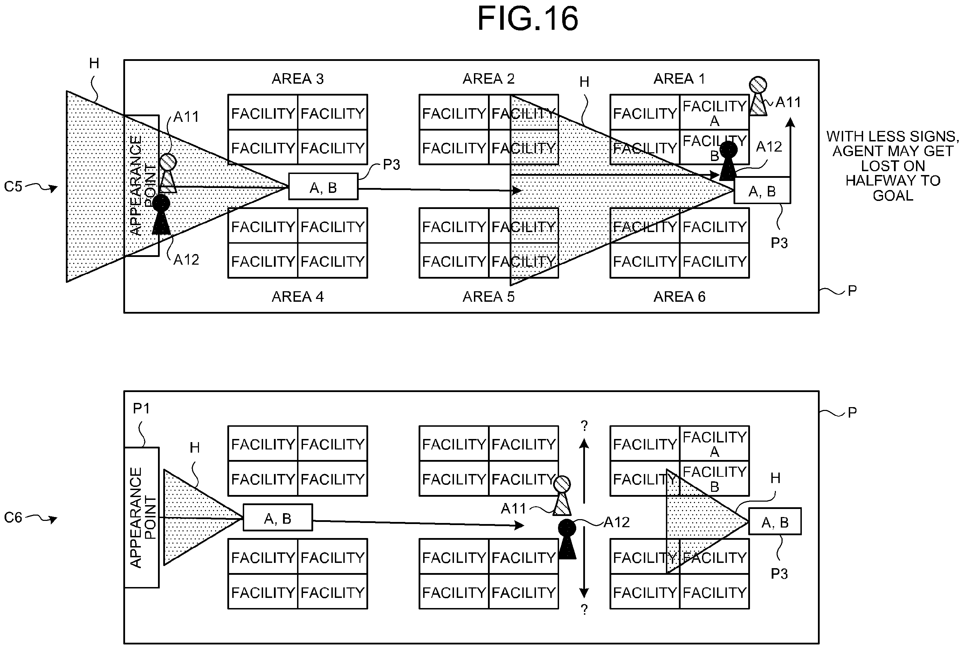

A case C5 in FIG. 16 represents the result of a simulation in which the reach area H of the sign P3 is set large. A case C6 represents the result of a simulation in the case where the reach area H is set small. As illustrated in FIG. 16, properly setting the reach area H of the sign P3 in the sign system plan enables examination of a plan without motions of the agents A 11 and A12, such as "pacing" and "getting lost".

As described above, the simulation apparatus 1 performs a process of arranging, in the virtual space P in which guide information is set, agents A each of which has perception information I and behaves in the virtual space P according to the perception information I. The simulation apparatus 1 performs a process of updating the perception information I of the agent according to the guide information that is provided according to the position of the agent A. The simulation apparatus 1 performs a process of deteriorating the perception information I on the basis of at least one of the behavior and the attribute of the agent A. For this reason, the simulation apparatus 1 is able to reproduce a behavior that is an actual human action, such as "pacing" or "getting lost", losing the connection between a destination and the position of a subject and is able to perform a people flow simulation enabling reproduction of deterioration of the perception information in human behaviors.

All or a given part of various process functions implemented by the simulation apparatus 1 may be implemented on a CPU (or a microcomputer, such as a MPU or a MCU (Micro Controller Unit)). Needless to say, all or a given part of the various process functions may be implemented on a program that is analyzed and executed by a CPU (or a microcomputer, such as a MPU or a MCU (Micro Controller Unit)) or hardware using a wired logic.

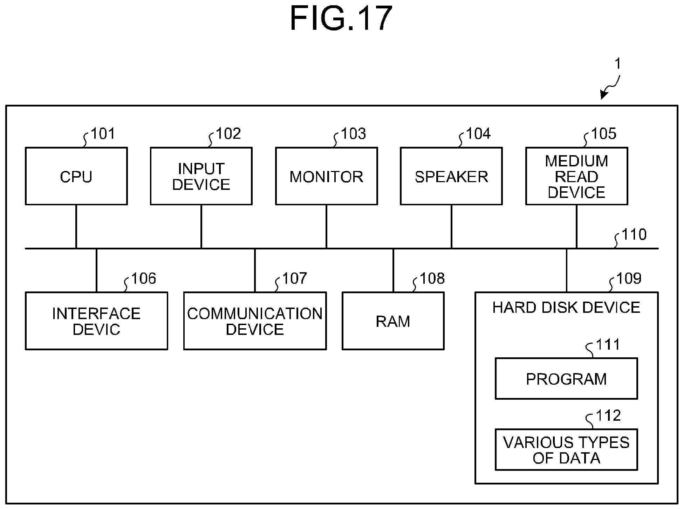

It is possible to implement the various processes described in the above-described embodiment by executing a program that is prepared in advance with a computer. An exemplary computer (hardware) that executes a program with the same functions as those of the above-described embodiment will be described below. FIG. 17 is a block diagram illustrating an exemplary hardware configuration of the simulation apparatus 1 according to the embodiment.

As illustrated in FIG. 17, the simulation apparatus 1 includes a CPU 101 that executes various arithmetic operation processes, an input device 102 that receives data inputs, a monitor 103, and a speaker 104. The simulation apparatus 1 includes a medium reading device 105 that reads a program, etc., from a recording medium, an interface device 106 for connecting to various devices, and a communication device 107 for communicating and connecting with external devices in a wired or wireless manner. The simulation apparatus 1 further includes a RAM 108 that temporarily stores various types of information and a hard disk device 109. Each component of the simulation apparatus 1 (101 to 109) is connected to a bus 110.

In the hard disk device 109, a program 111 for executing the various processes described in the above-described embodiment is stored. In the hard disk device 109, various types of data 112 that the program 111 refers to are stored. The input device 102, for example, receives an input of operation information from the operator of the simulation apparatus 1. The monitor 103 displays various screens that the operator operates. For example, a printing device, etc., is connected to the interface device 106. The communication device 107 is connected to a communication network, such as a LAN (Local Area Network) and communicates various types of information with an external device via the communication network.

The CPU 101 reads the program 111 that is stored in the hard disk device 109, loads the program 111 into the RAM 108, and executes the program 111 to perform various processes. The program 111 need not be stored in the hard disk device 109. For example, the simulation apparatus 1 may read and execute the program 111 that is stored in a storage medium readable by the simulation apparatus 1. The storage medium readable by the simulation apparatus 1 corresponds to, for example, a portable recording medium, such as a CD-ROM, a DVD disk, a USB (Universal Serial Bus) memory, a semiconductor memory, such as a flash memory, a hard disk drive, etc. The program may be stored in a device connected to, a public line, the Internet, a LAN, or the like and the simulation apparatus 1 may read the program the device and execute the program.

### Reference Signs List

- 1: SIMULATION APPARATUS
- 10: INPUT UNIT
- 11: SPATIAL INFORMATION
- 12: SIGN SYSTEM PLAN
- 13: PEDESTRIAN INFORMATION
- 20: INPUT INFORMATION STORAGE UNIT
- 30: SIMULATION MANAGER
- 40: SIGN SYSTEM CHANGE UNIT
- 50: PEDESTRIAN BEHAVIOR EXECUTION UNIT
- 60: SIMULATION RESULT OUTPUT UNIT
- 70: AGENT INFORMATION STORAGE UNIT
- 101: CPU
- 111: PROGRAM
- 112: VARIOUS TYPES OF DATA
- A, A1 TO A3: AGENT
- H: REACH AREA
- I: PERCEPTION INFORMATION
- P1: APPEARANCE POINT
- P2: FACILITY
- P3: SIGN

## Claims

1. A simulation program that causes a computer to execute a process comprising:
arranging an agent in a virtual space that includes one or a plurality of places where guide information is set, the agent having perception information and behaving according to the perception information in the virtual space;
updating the perception information of the agent according to guide information that is provided according to the position of the agent in the virtual space; and
deteriorating the perception information, degree of the deteriorating being determined on the basis of at least any one of a behavior of the agent and an attribute of the agent.

2. The simulation program according to claim 1, wherein the deteriorating includes deteriorating the perception information on the basis of first limitation information that is defined in the guide information.

3. The simulation program according to claim 1 or 2, wherein the deteriorating includes deteriorating the perception information on the basis of second limitation information that is defined in association with the attribute of the agent.

4. The simulation program according to any one of claims 1 to 3, wherein the deteriorating includes deteriorating the perception information according to a progress of the behavior of the agent from the updating the perception information according to the guide information.

5. The simulation program according to any one of claims 1 to 3, wherein the limiting includes deteriorating the perception information according to a progress of time from the updating the perception information according to the guide information.

6. The simulation program according to claim 2, wherein the first limitation information is set according to category information that is defined in each of the sets of guide information.

7. A simulation program that causes a computer to execute a process comprising:
arranging an agent in a virtual space that includes one or a plurality of places where guide information is set, the agent having perception information and behaving according to the perception information in the virtual space;
updating the perception information of the agent according to guide information that is provided according to the position of the agent in the virtual space; and
deteriorating the perception information, degree of the deteriorating being determined on the basis of a behavior of the agent or an attribute of the agent.

8. A simulation method for a computer to execute a process comprising:
arranging an agent in a virtual space that includes one or a plurality of places where guide information is set, the agent having perception information and behaving according to the perception information in the virtual space;
updating the perception information of the agent according to guide information that is provided according to the position of the agent in the virtual space; and
deteriorating the perception information, degree of the deteriorating being determined on the basis of at least any one of a behavior of the agent and an attribute of the agent.

9. The simulation method according to claim 8, wherein the deteriorating includes deteriorating the perception information on the basis of first limitation information that is defined in the guide information.

10. The simulation method according to claim 8 or 9, wherein the deteriorating includes deteriorating the perception information on the basis of second limitation information that is defined in association with the attribute of the agent.

11. The simulation method according to claim 8 or 9, wherein the deteriorating includes deteriorating the perception information according to a progress of the behavior of the agent from the updating the perception information according to the guide information.

12. The simulation method according to any one of claims 8 to 10, wherein the limiting includes deteriorating the perception information according to a progress of time from the updating the perception information according to the guide information.

13. The simulation method according to claims 9, wherein wherein the first limitation information is set according to category information that is defined in each of the sets of guide information.

14. A simulation method for a computer to execute a process comprising:
arranging an agent in a virtual space that includes one or a plurality of places where guide information is set, the agent having perception information and behaving according to the perception information in the virtual space;
updating the perception information of the agent according to guide information that is provided according to the position of the agent in the virtual space; and
deteriorating the perception information, degree of the deteriorating being determined on the basis of a behavior of the agent or an attribute of the agent.

15. A simulation apparatus comprising a processor that executes each of processes of
arranging an agent in a virtual space that includes one or a plurality of places where guide information is set, the agent having perception information and behaving according to the perception information in the virtual space;
updating the perception information of the agent according to guide information that is provided according to the position of the agent in the virtual space; and
deteriorating the perception information, degree of the deteriorating being determined on the basis of at least any one of a behavior of the agent and an attribute of the agent.

16. The simulation apparatus according to claim 15, wherein the deteriorating includes deteriorating the perception information on the basis of first limitation information that is defined in the guide information.

17. The simulation apparatus according to claims 15 or 16, wherein the deteriorating includes deteriorating the perception information on the basis of second limitation information that is defined in association with the attribute of the agent.

18. The simulation apparatus according to any one of claims 15 to 17, wherein the deteriorating includes deteriorating the perception information according to a progress of the behavior of the agent from the updating the perception information according to the guide information.

19. The simulation apparatus according to any one of claims 15 to 17, wherein the limiting includes deteriorating the perception information according to a progress of time from the updating the perception information according to the guide information.

20. The simulation apparatus according to claim 16, wherein the first limitation information is set according to category information that is defined in each of the sets of guide information.

21. A simulation apparatus comprising a processor configured to execute each of processes of
arranging an agent in a virtual space that includes one or a plurality of places where guide information is set, the agent having perception information and behaving according to the perception information in the virtual space;
updating the perception information of the agent according to guide information that is provided according to the position of the agent in the virtual space; and
deteriorating the perception information, degree of the deteriorating being determined on the basis of a behavior of the agent or an attribute of the agent.
